# EUROPEAN PATENT APPLICATION

(11) **EP 4 811 657 A1**
(43) Date of publication of application: **23.09.2026**
(21) Application number: 26161970.4
(22) Date of filing: 03.03.2026
(51) Int. Cl.: H03F 1/34, H03F 3/45

(54) **DUAL-PATH DC CANCELLATION FRONT-END AMPLIFIER**

(30) Priority: 18.03.2025 US 202519083202
(71) Applicant: Avago Technologies International Sales Pte. Limited, Singapore 768923 (SG)
(72) Inventor: Lu, Junjie, Irvine, CA, 92620 (US); Guo, Jing, Irvine, CA, 92618 (US); Jiang, Xicheng, Irvine, CA, 92612 (US)
(74) Representative: Grünecker Patent- und Rechtsanwälte PartG mbB

(57) **Abstract**

A device is provided herein. The device includes a signal input, an operational amplifier (op-amp) comprising a non-inverting op-amp input, an inverting op-amp input, and an op-amp output, a summer coupled to the op-amp output, a second summer input coupled to the signal input, and a summer output, and a low-pass filter comprising a low-pass filter input coupled to the summer output and a low-pass filter output coupled to the inverting op-amp input. The device processes electrophysiology signals by combining feedforward and feedback paths to achieve DC offset and low-frequency interference rejection while maintaining high input impedance and signal amplification.

## Description

### BACKGROUND

Electrophysiology signals provide valuable insights into various physiological processes and are widely used in wearable devices, medical diagnostics and health monitoring. These signals, which include electrocardiograms (ECG), electromyograms (EMG), and electroencephalograms (EEG), typically have small amplitudes in the range of microvolts to millivolts. Acquiring and processing these weak signals presents challenges, particularly in the presence of larger DC offsets and low-frequency interference that can arise from electrode-skin interfaces and environmental factors.

Wearable devices for continuous health monitoring have gained popularity due to their potential for early detection of health issues and personalized healthcare. However, the use of dry electrodes in these devices, while more comfortable for long-term wear, introduces additional complexities in signal acquisition. Dry electrodes often have higher impedance and are more susceptible to motion artifacts compared to traditional wet electrodes used in clinical settings.

### BRIEF DESCRIPTION OF FIGURES

Non-limiting and non-exhaustive examples are described with reference to the following figures.
FIG. 1 illustrates a circuit diagram of a front-end amplifier, in accordance with one or more embodiments of the disclosure.
FIG. 2 illustrates another circuit diagram of a front-end amplifier, in accordance with one or more embodiments of the disclosure.
FIG. 3 illustrates a block diagram of a wearable device incorporating a front-end amplifier, in accordance with one or more embodiments of the disclosure.
FIG. 4 illustrates a manufacturing process for producing a front-end amplifier, in accordance with one or more embodiments of the disclosure.

### DETAILED DESCRIPTION

The following describes technical solutions in this specification with reference to the accompanying drawings. Exemplary embodiments are described in detail with reference to the accompanying drawings.

The terminology used herein is for describing various examples only and is not to be used to limit the disclosure. Unless otherwise defined, all terms, including technical and scientific terms, used herein have the same meaning as commonly understood by one of ordinary skill in the art to which this disclosure pertains and after an understanding of the disclosure of this application.

Terms, such as those defined in commonly used dictionaries, are to be interpreted as having a meaning that is consistent with their meaning in the context of the relevant art and the disclosure of this application. Although the present technology has been described by referring to certain examples, workers skilled in the art will recognize that changes may be made in form and detail without departing from the scope of the discussion.

Conventional front-end amplifiers for electrophysiology signals often struggle to effectively process the weak signals in the presence of larger DC offsets and low-frequency interference. These systems may have difficulty maintaining signal integrity, particularly when used with dry electrodes in wearable devices. The challenges are compounded by the higher impedance and increased susceptibility to motion artifacts associated with dry electrodes, which can lead to degraded signal quality and reduced accuracy in health monitoring applications.

The described technology may address these challenges by providing a front-end amplifier system that incorporates a dual-path DC cancellation network. This system may include a summer with inputs from both the amplifier output and the original input signal, combined with a low-pass filter in the feedback path. The dual-path approach may allow for more effective rejection of DC offsets and low-frequency interference while maintaining the desired signal components.

This technology may improve the performance of wearable health monitoring devices by enabling more accurate acquisition and processing of weak electrophysiology signals. The dual-path DC cancellation may enhance the signal-to-noise ratio by attenuating unwanted low-frequency components while amplifying the desired signal frequencies.

The described technology may be implemented in various wearable devices and systems that utilize electrodes for electrophysiology (EP) signal acquisition. These may include smart watches, fitness trackers, and health monitoring bands that can continuously track heart rate, detect arrhythmias, or monitor stress levels. The technology may also be incorporated into smart clothing, such as shirts or chest straps with integrated electrodes, which may provide more comprehensive ECG monitoring during physical activities.

In addition to wearable devices, the technology may be implemented in portable medical devices used for ambulatory monitoring, such as Holter monitors or event recorders. These devices may benefit from improved signal quality and reduced motion artifacts, potentially leading to more accurate diagnoses and better patient outcomes. The technology may also find applications in consumer electronics like smartphones or tablets, which may incorporate electrodes in their casings or accessories for on-demand ECG measurements. Smart home devices, such as bathroom scales or sleep monitoring systems, may utilize this technology to provide more accurate health data to users. In clinical settings, the technology may be integrated into patient monitoring systems, including bedside monitors and telemetry devices, to improve the quality of continuous EP signal acquisition. It may also be used in specialized medical equipment such as EEG headsets for brain activity monitoring or EMG systems for muscle activity assessment. Furthermore, the technology may be applied in non-medical fields where biosignal monitoring is relevant, such as in sports performance analysis systems, fatigue monitoring devices for drivers or pilots, or even in human-computer interaction devices that use muscle activity as input signals.

While the front-end amplifiers described below are discussed with respect to signal acquisition from an electrode of a wearable device, they may be applied to any suitable system where weak signal amplification and DC offset rejection are desired. The principles and architecture of these amplifiers may be adapted for use in various fields beyond wearable health monitoring. For example, in atomic force microscopy (AFM), where extremely small deflections of a cantilever need to be detected, a front-end amplifier with high input impedance, low noise, and effective DC cancellation may support accurately measuring the tiny electrical signals generated by the AFM probe as it scans a sample surface. In this application, the amplifier's ability to reject low-frequency drift and environmental interference while amplifying the desired high-frequency components of the signal may significantly enhance the resolution and stability of the AFM measurements.

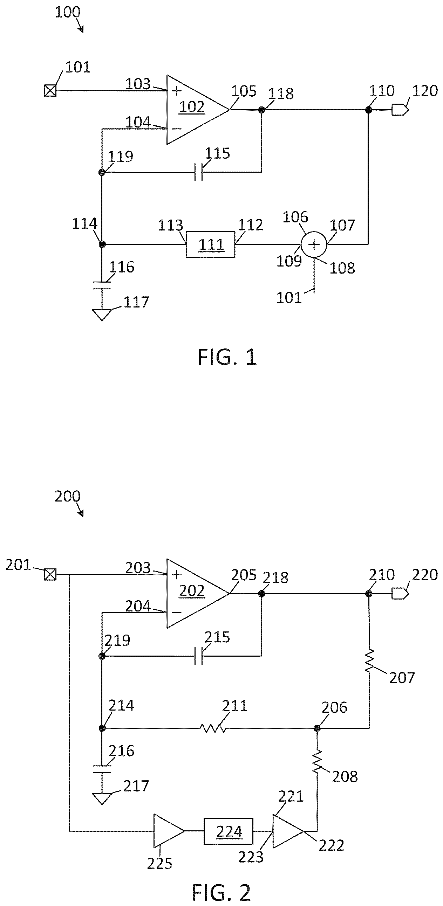

FIG. 1 illustrates a front-end amplifier 100 for processing electrophysiology signals. Front-end amplifier 100 may include a signal input 101, an operational amplifier (op-amp) 102, a summer 106, and a low-pass filter 111. In some examples, front-end amplifier 100 may be implemented using discrete components on a printed circuit board. For example, op-amp 102 may be a discrete op-amp chip, while summer 106 and low-pass filter 111 may be constructed using discrete resistors and capacitors. Alternatively, front-end amplifier 100 may be implemented as an integrated circuit, with components fabricated on a single semiconductor die. In some implementations, front-end amplifier 100 may be implemented as a discrete device. In further examples, front-end amplifier 100 may be integrated with a sensor, such as an electrode, on a single substrate. In other implementations, front-end amplifier 100 may be integrated with digital components on a system-on-chip (SOC). For example, front-end amplifier 100 may be fabricated on the same die as an analog-to-digital converter and processor, allowing for a compact single-chip solution for electrophysiology signal acquisition and processing.

Signal input 101 may be configured to receive an input signal, such as an electrophysiology signal from a sensor or electrode. Op-amp 102 may include a non-inverting input 103, an inverting input 104, and an op-amp output 105. Non-inverting input 103 may be connected to signal input 101 to receive the input signal. The architecture may utilize a high-gain operational amplifier with a CMOS transistor as the input. The electrophysiology signal may be connected to the non-inverting (+) terminal of the op-amp. In this example, non-inverting input 103 would be connected only to the gate of the CMOS transistor with the gate may be isolated from the rest of the circuitry by the oxide insulator. Thus, the input impedance for the electrophysiology signal may be extremely high. This may help prevent attenuation of the electrophysiology signal when a low-conductance dry electrode is used. To further reduce input leakage, a thick-oxide IO MOS transistor may be used as the input transistor. For example, a thick-oxide IO MOS transistor that reduces the input leakage to below 10 pA may result in an effective input impedance of more than 100 GΩ.

Some examples may utilize capacitive feedback to amplify electrophysiology (EP) signals while reducing noise and power requirements. Conventional resistive feedback networks may generate thermal noise and consume power, which can degrade signal-to-noise ratio (SNR) and increase power consumption. The capacitive feedback approach may offer several advantages: capacitors do not generate thermal noise, potentially improving SNR; no DC current flows through capacitors, potentially reducing power consumption; the capacitor network may facilitate implementation of a high-pass transfer function; and capacitors may have better matching and lower temperature drift than resistors in modern CMOS processes, potentially improving gain accuracy and temperature stability.

In the illustrated example, a first capacitor 115 and a second capacitor 116 may form a capacitive network that helps establish the gain characteristics of front-end amplifier 100. First capacitor 115 may connect between op-amp output 105 and inverting input 104 via feedback capacitor connections 118 and 119. Second capacitor 116 may connect between inverting input 104 and ground 117. This capacitor configuration, in conjunction with other circuit elements, may contribute to setting the overall gain and frequency response of the amplifier. For example, the operational amplifier 102 and feedback capacitors 115, 116 may implement a transfer function given by T(s)=VOUT(s)/VIN(s)= (C1+C_{FB} )/C_{FB}, where C1 represents the capacitance of second capacitor 116 and C_{FB} represents the capacitance of first capacitor 115.

Front-end amplifier 100 may incorporate both feedback and feedforward signal paths to process the input signal. This dual-path configuration may enable effective rejection of DC offsets and low-frequency interference while preserving desired signal components. For example, dual path DC cancellation may combine both the input (feedforward) and output (feedback) signals via summer 106 before sending them to the inverting input 104 of op-amp 102 through low-pass filter 111. As DC offset and low-frequency interference may be substantially larger than the signal of interest, thorough DC cancellation can be beneficial, and even small DC leakage in conventional approaches may be undesirable for some applications.

Summer 106 may combine signals from both the feedback and feedforward paths. The feedback path may include feedback connection 110 from op-amp output 105 to first summer input 107. The feedforward path may connect signal input 101 directly to second summer input 108. First summer input 107 may receive the feedback signal from op-amp output 105, while second summer input 108 may receive the feedforward signal directly from signal input 101. Summer output 109 may provide a combined signal incorporating components from both paths for further processing.

Low-pass filter 111 may process the combined signal from summer output 109. Low-pass filter input 112 may connect to summer output 109, allowing low-pass filter 111 to receive the combined signal. Low-pass filter 111 may attenuate high-frequency components while passing lower frequency signals, including DC and low-frequency content The term "low-pass filter" may apply to a circuit that allows signals below a certain frequency to pass through while attenuating signals above that frequency. The frequency at which the filter begins to attenuate higher frequency signals is known as the corner frequency. In particular, examples are discussed with respect to the -3dB corner frequency, which is the frequency at which higher frequencies are attenuated by at least 3dB (e.g., the gain is -3dB). In particular, the term 'low' does not imply any particular corner frequency, an example low-pass filter might be configured with a corner frequency from Hz to GHz (or higher).

The filtered signal from low-pass filter output 113 may connect to inverting input 104 of op-amp 102 via feedback connection 114. This configuration may allow the low-frequency components passed by low-pass filter 111 to be subtracted from the input signal at non-inverting input 103. This subtraction may effectively remove DC offset and low-frequency interference from the amplified signal.

The processed output signal may be available at front-end amplifier output 120, which may connect to op-amp output 105. This output may represent an amplified and conditioned version of the input signal, with reduced DC offset and low-frequency interference. The combination of dual-path signal processing, capacitive feedback, and low-pass filtering may enable front-end amplifier 100 to effectively amplify weak electrophysiology signals while attenuating unwanted low-frequency components.

FIG. 2 illustrates a front-end amplifier 200, which may be an example implementation of front-end amplifier 100 shown in FIG. 1. In front-end amplifier 200, the summer circuit of FIG. 1 may be implemented using a resistor network. The low-pass filter may be realized through the combination of a resistor and feedback capacitor.

Front-end amplifier 200 may include a signal input 201 connected to an op-amp 202. Op-amp 202 may comprise a non-inverting input 203, an inverting input 204, and an op-amp output 205. In some examples, op-amp 202 may be a high-gain operational amplifier designed to process weak electrophysiology signals. For example, op-amp 202 may utilize a folded-cascode architecture, which may provide high gain and wide bandwidth while maintaining stability. The op-amp may include multiple stages, such as a differential input stage, a gain stage, and an output buffer stage. In some cases, op-amp 202 may be implemented using CMOS technology. The non-inverting input 203 may be connected to signal input 201, which may comprise a CMOS transistor. This input transistor may be a thick-oxide IO MOS transistor to reduce input leakage current. The gate of this CMOS transistor may be isolated from the rest of the circuitry by the oxide insulator, potentially resulting in an extremely high input impedance. This configuration may help prevent attenuation of the input electrophysiology signal, particularly when used with low-conductance dry electrodes. The inverting input 204 may receive the feedback signal, while op-amp output 205 may provide the amplified and processed signal. In some implementations, op-amp 202 may incorporate chopper stabilization techniques to reduce low-frequency noise and offset. For example, the physical implementation of op-amp 202 may vary depending on the specific application requirements. It may be fabricated as part of an integrated circuit using standard CMOS processes, or it may be implemented using discrete components on a printed circuit board for prototyping or specialized applications.

Front-end amplifier 200 may include a feedback capacitor network comprising a first capacitor 215 and a second capacitor 216. First capacitor 215 may be connected between op-amp output 205 and inverting input 204 via feedback capacitor connections 218 and 219. Second capacitor 216 may be connected to ground 217. The capacitances of first capacitor 215 and second capacitor 216 may establish the signal gain of front-end amplifier 200. In various implementations, front-end amplifier 200 may amplify electrophysiology (EP) signals by a wide range of, such as a factor of 2x-100x , which may help reduce noise and power requirements for subsequent signal processing stages. The ratio of these capacitances may be adjusted to set the amplification factor according to the transfer function T(s)=VOUT(s)/VIN(s)= (C1+Cfb)/Cfb, where C1 represents the capacitance of second capacitor 216 and Cfb represents the capacitance of first capacitor 215.

In front-end amplifier 200, the summer circuit of FIG. 1 may be implemented using a resistor network. In some examples, the summer may be implemented passively with a resistor network comprising a first resistor 207 and a second resistor 208. First resistor 207 may be coupled in series to op-amp output 205 via a feedback connection 210. Second resistor 208 may be coupled in series to signal input 201, providing a feedforward path. Transmission lines through first resistor 207 and second resistor 208 may be connected at a summing node 206 that is coupled in series to a third resistor 211. The resistor network could be physically implemented in various ways. For example, in a CMOS circuit, all three resistors could be implemented as poly resistors. Alternatively, the first and second resistors could be poly resistors while the third is a switched capacitor resistor. Another CMOS implementation could use switched capacitor resistors for all three resistors.

Third resistor 211 may be connected to inverting input 204 via a feedback connection 214, which may be connected in parallel to first capacitor 215. Together, third resistor 211 and first capacitor 215 may implement a low-pass RC filter. The properties of these components may determine the filter's cutoff frequency and roll-off characteristics. The resistance values of first resistor 207, second resistor 208, and third resistor 211 may be chosen to provide effective DC cancellation and low-pass filtering characteristics. The cutoff frequency of the low-pass filter formed by third resistor 211 and first capacitor 215 may be tuned by adjusting the RC time constant, allowing for optimization of the DC and low-frequency interference rejection while preserving the desired signal components.

Front-end amplifier 200 may comprise a buffer 221 included in the feedforward path. Buffer 221 may have a buffer input 223 coupled to signal input 201 and a buffer output 222 coupled to second resistor 208. Buffer 221 may comprise an amplifier having a voltage gain greater than unity, which may help compensate for signal attenuation caused by the resistor network. Amplifier 200 may further include a low-pass filter 224 between signal input 201 and buffer input 223. This configuration may help reduce higher frequency components and reduce the swing requirement for buffer 221.

In some cases, front-end amplifier 200 may further comprise components to maintain a high input impedance. For example, amplifier 200 an input buffer 225 coupled in series between signal input 201 and low-pass filter 224. For example, input buffer 225 may comprise a unity gain buffer.

The gain of buffer 221 may be designed to compensate for the loss introduced by the passive summer, ensuring that the overall gain from signal input 201 to summing node 206 is approximately unity at low frequencies. For instance, buffer 221 may have a gain of about 1.5x. The low-pass filter 224 may be implemented as a small RC filter to attenuate higher frequency components, as this path primarily processes low-frequency signals. Implementations may be designed with a wide range of configurations to support a range of feedback factors. For example, parameters may be configured to balance aspects such as noise introduced by components such as resistor 211 and gain factors for buffer 221 in view of system supply voltages. For instance, resistance values of first resistor 207 (R_{FB}) and second resistor 208 (R_{FF}) may be chosen such that R_{FB} = 0.5 *R_{FF}.* With this configuration and a buffer gain of 1.5x, the signal at summing node 206 may be represented as: $sum = IN + \frac{1}{3} ⋅ OUT$ where IN represents the input signal from signal input 201 and OUT represents the output signal from op-amp output 205. This configuration may allow for effective combining of the input and feedback signals while maintaining appropriate signal levels throughout the circuit.

The combination of buffer 221 and the resistor network forming the summer may add minimal power consumption and noise to the system. For instance, the DC cancellation path may only be required to process DC to low-frequency signals, which may result in minimal bandwidth requirements for this path. Consequently, the power consumption of buffer 221 and the associated circuitry may be kept low. Second, the low-pass filter formed by third resistor 211 and first capacitor 215 may attenuate thermal noise from the summer path, potentially reducing it by more than a factor of 10.

The overall configuration of front-end amplifier 200 may result in a high-pass transfer function that may support a variety of corner frequencies. For instance, configurations may have corner frequencies between 0.1 Hz and 100 Hz. Parameters may be configured to provide a corner frequency corresponding to an input signal frequency range that is to be captured. Implementations of amplifier 200 may support a wide range of target frequencies, such as in a range between 10 Hz to 1 kHz. For example, with a corner frequency of around 1 Hz, amplifier 200 may effectively attenuate DC offset and low-frequency interference while passing EP signals typically in the frequency range of 10 Hz to 150 Hz. This configuration may allow front-end amplifier 200 to achieve effective DC cancellation and low-frequency interference rejection while minimizing additional noise and power consumption, which may be beneficial in wearable and low-power applications.

In a particular example, where buffer 221 has a 1.5x gain and R_{FB} = 0.5R_{FF}, where R_{FB} is the resistance of resistor 207 (e.g., the feedback resistor) and R_{FF} is the resistance of resistor 208 (e.g., the feedforward resistor), he system transfer function STF(s) of front-end amplifier 200 may be expressed as: $STF \left(s\right) = \frac{OUT \left(s\right)}{IN \left(s\right)} = \frac{{sR}_{LPF} \left({C}_{1}+{C}_{fb}\right)}{1 + 3 ⋅ {sR}_{LPF} {C}_{fb}}$ where s is the complex frequency variable, C_{fb} is the capacitance of first capacitor 215, C₁ is the capacitance of second capacitor 216, and R_{LPF} is the resistance of third resistor 211.

As can be seen from the transfer function, at DC or low-frequency (as s approaches 0), the magnitude of STF also approaches 0. In this example, the -3 dB corner frequency of the high-pass function is given by: ${f}_{hpf} = \frac{1}{6 {πR}_{LPF} {C}_{fb}}$ Compared to conventional high-pass filters implemented with only R and C, for which the corner frequency is given by 1/(2π R_{LPF}C_{fb}), this design may require only 1/3 of the RC product value to realize the same corner frequency. This may help to reduce the silicon area and parasitic effects due to large on-chip RC components. At EP signal frequency (f_{sig} >> f_{hpf}), the STF may be simplified to (C₁ + C_{fb})/C_{fb}. Therefore, at EP signal frequency, front-end amplifier 200 may provide a gain determined by the capacitor ratio. This transfer function may represent the high-pass characteristics of the amplifier combined with its gain factor, potentially attenuating low-frequency components while amplifying and passing higher frequency signals. The configuration may allow front-end amplifier 200 to achieve effective DC cancellation and low-frequency interference rejection while minimizing additional noise and power consumption, which may be beneficial in wearable and low-power applications.

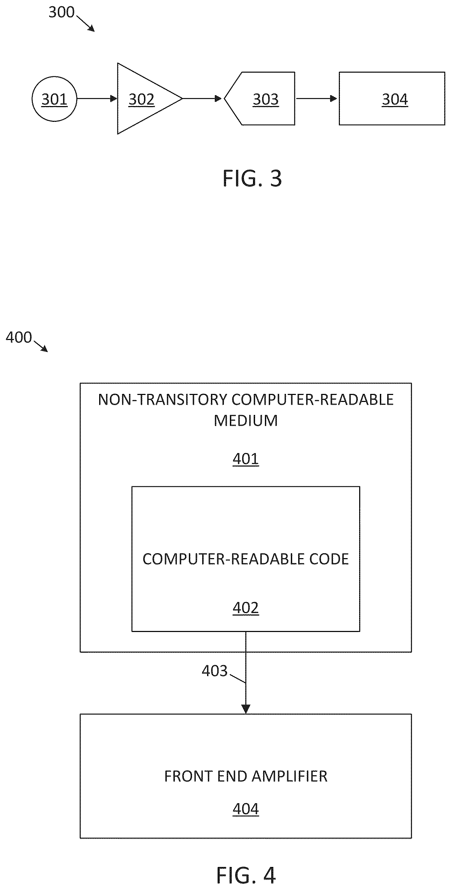

FIG. 3 illustrates a block diagram of a wearable device 300. Wearable device 300 may include an electrode 301, a front-end amplifier 302, an analog-to-digital converter (ADC) 303, and a processor 304. Wearable device 300 may be implemented in various form factors such as smartwatches, fitness bands, chest straps, or smart clothing with integrated sensors. The device may incorporate additional components not explicitly shown, such as input/output interfaces (e.g. displays, buttons, haptic feedback), wireless communication modules (e.g. Bluetooth, Wi-Fi), memory storage, and power management systems. Other sensors may also be included, such as accelerometers, gyroscopes, or optical heart rate sensors, to provide complementary physiological and motion data.

The illustrated components may be implemented in various manners. For example, front-end amplifier 302, ADC 303, and processor 304 may be integrated as components of a system-on-chip (SOC), such as a very-large-scale integration (VLSI) integrated circuit. This high level of integration may allow for a compact and power-efficient design, potentially reducing the overall size and power consumption of wearable device 300. As another example, front-end amplifier 302 may be integrated directly with electrode 301 to form a single sensor unit, while ADC 303 and processor 304 may be integrated into a separate application-specific integrated circuit (ASIC). In other cases, wearable device 300 may be implemented using discrete components. For instance, the components may be mounted on one or more printed circuit boards (PCB).

Electrode 301 may be configured to interface with a user's skin and collect electrophysiology signals. In some implementations, electrode 301 may be designed for extended use and biocompatibility, making electrode 301 suitable for continuous health monitoring applications. For example, electrode 301 may comprise a conductive polymer material or a metal-coated fabric that provides electrical contact with the skin.

Front-end amplifier 302 may be coupled to electrode 301 and may receive the collected electrophysiology signals as input. Front-end amplifier 302 may be an implementation of front-end amplifier 100 or front-end amplifier 200, as described in relation to FIG. 1 and FIG. 2. Front-end amplifier 302 may be configured to amplify and condition the weak electrophysiology signals collected by electrode 301.

In some cases, front-end amplifier 302 may include a signal input coupled to electrode 301, an op-amp with a non-inverting input connected to the signal input, an inverting input, and an op-amp output. Front-end amplifier 302 may also include a summer with a first summer input coupled to the op-amp output, a second summer input coupled to the signal input, and a summer output. Additionally, front-end amplifier 302 may incorporate a low-pass filter with a low-pass filter input coupled to the summer output and a low-pass filter output coupled to the inverting op-amp input.

ADC 303 may be coupled to the output of front-end amplifier 302. ADC 303 may be configured to convert the amplified and conditioned analog signals from front-end amplifier 302 into digital format. This conversion may allow for easier processing and analysis of the electrophysiology signals by subsequent digital components. For example, ADC 303 may be a 24-bit ADC with a sampling rate of 1 kHz, which may be suitable for capturing the frequency content of many electrophysiology signals.

Processor 304 may be connected to the output of ADC 303. Processor 304 may be configured to receive and process the digitized electrophysiology signals. In some cases, processor 304 may perform various signal processing tasks, such as filtering, feature extraction, or pattern recognition, to derive information from the electrophysiology signals. Processor 304 may include, for example, a digital signal processor, a microcontroller, or a hybrid/combined processor incorporating features of both.

The signal flow in wearable device 300 may begin with electrode 301 collecting electrophysiology signals from the user's skin. These signals may then be passed to front-end amplifier 302, which may amplify the weak signals and reject unwanted DC offset and low-frequency interference. The amplified and conditioned analog signals may then be converted to digital format by ADC 303. Finally, the digitized signals may be processed by processor 304, for example, to extract physiological information, to transmit to another system, etc.

FIG. 4 illustrates a manufacturing process 400 for producing a front-end amplifier, such as front-end amplifier 302 described in relation to FIG. 3. Manufacturing process 400 may include a non-transitory computer-readable medium 401, computer-readable code 402, and a semiconductor design and fabrication process 403.

Non-transitory computer-readable medium 401 may be any type of storage device capable of storing computer-readable instructions. In some cases, non-transitory computer-readable medium 401 may be a hard drive, solid-state drive, flash memory, or other form of persistent storage. Non-transitory computer-readable medium 401 may contain computer-readable code 402, which may include instructions for implementing the design of front-end amplifier 404. Computer-readable code 402 can be stored in any non-transitory computer-readable medium 401 such as a semiconductor medium, solid-state medium, magnetic medium, optical medium, etc. For example, computer-readable medium 401 might comprise a memory device, storage device, registers (e.g., static RAM), cache device, etc.

Computer-readable code 402 may comprise a set of instructions that, when executed by a computer system, may define the structure and functionality of front-end amplifier 404. These instructions may include specifications for the various components of front-end amplifier 404, such as op-amp 202, summer 106, and low-pass filter 111. In some cases, computer-readable code 402 may also include parameters for the resistor and capacitor values used in the front-end amplifier design. In some configurations, the computer-readable code 402 is used at one or more stages of a semiconductor design and fabrication process 403, including an electronic design automation (EDA) stage, to fabricate 403 an integrated circuit 404. The computer-readable code 402 may additionally or alternatively enable the definition, modelling, simulation, verification and/or testing of an apparatus embodying the concepts described herein.

For example, the computer-readable code 402 can be embodied in code defining a hardware description language (HDL) representation of the circuitry 404. For example, the code may define a register-transfer-level (RTL) abstraction of one or more logic circuits for defining an apparatus embodying the concepts. The code may define an HDL representation of the one or more logic circuits embodying the apparatus in Verilog, SystemVerilog, Chisel, or VHDL (Very High-Speed Integrated Circuit Hardware Description Language) as well as intermediate representations such as FIRRTL. Computer-readable code 402 may provide definitions embodying the circuitry using system-level modelling languages such as SystemC and SystemVerilog or other behavioral representations of the concepts that can be interpreted by a computer to enable simulation, functional and/or formal verification, and testing of the circuitry.

In some examples, the computer-readable code 402 may define a low-level description of integrated circuit components that embody concepts described herein, such as one or more netlists or integrated circuit layout definitions, including representations such as GDSII. The one or more netlists or other computer-readable representation of integrated circuit components may be generated by applying one or more logic synthesis processes to an RTL representation to generate definitions for use in fabrication 403 of an apparatus embodying the invention. In some examples, the one or more logic synthesis processes can generate from the computer-readable code 402 a bitstream to be loaded into a field programmable gate array (FPGA) to configure the FPGA to implement the described circuitry 404. The FPGA may be deployed for the purposes of verification and test of the concepts prior to fabrication 403 in an integrated circuit or the FPGA may be deployed in a product directly.

Semiconductor design and fabrication process 403 may utilize computer-readable code 402 to produce front-end amplifier 404. This process may involve multiple stages of design, simulation, verification, and physical fabrication. In some cases, semiconductor design and fabrication process 403 may comprise any stage of a VLSI (Very Large Scale Integration) design and fabrication process.

The initial stages of semiconductor design and fabrication process 403 may involve translating the instructions in computer-readable code 402 into a detailed circuit design. This may include creating schematic diagrams and layout designs for front-end amplifier 404. During this stage, the specific connections and arrangements of components such as op-amp 202, summer 106, and low-pass filter 111 may be defined.

Following the design phase, semiconductor design and fabrication process 403 may include simulation and verification steps. These steps may help ensure that front-end amplifier 404 meets the desired performance specifications, such as input impedance, gain, and frequency response characteristics. Simulations may be performed to verify the functionality of the dual-path DC cancellation network and the high-pass transfer function of front-end amplifier 404.

Once the design has been verified, semiconductor design and fabrication process 403 may proceed to the physical fabrication of front-end amplifier 404. This may involve a series of steps including wafer processing, photolithography, etching, and deposition of various materials to create the transistors, resistors, and capacitors that make up front-end amplifier 404.

After fabrication, front-end amplifier 404 may undergo testing and characterization to ensure compliance with the design specifications. This may include measurements of input impedance, gain accuracy, frequency response, and noise performance. The testing process may also verify the effectiveness of the DC offset and low-frequency interference rejection capabilities of front-end amplifier 404.

Manufacturing process 400 may enable the production of front-end amplifier 404 with consistent performance characteristics across multiple units. By utilizing non-transitory computer-readable medium 401 and computer-readable code 402, the design of front-end amplifier 404 may be easily modified and optimized for different applications or performance requirements.

Those skilled in the art will also appreciate the arrangement or interconnection of components such as "coupled," "connected," "on," "under," or similar wording allows for indirect connections, or intervening components or layers.

As used herein, unless otherwise limited or defined, "or" indicates a non-exclusive list of components or operations that may be present in any variety of combinations, rather than an exclusive list of components that may be present as alternatives to each other. For example, a list of "A, B, or C" indicates options of: A; B; C; A and B; A and C; B and C; and A, B, and C.

Correspondingly, the term "or" as used herein is intended to indicate exclusive alternatives when preceded by terms of exclusivity, such as, e.g., "either," "one of," or "exactly one of." Further, a list preceded by "one or more" (and variations thereon) and including "or" to separate listed elements indicates options of one or more of any or all of the listed elements.

For example, the phrases "one or more of A, B, or C" and "at least one of A, B, or C" indicate options of: one or more A; one or more B; one or more C; one or more A and one or more B; one or more B and one or more C; one or more A and one or more C; and one or more of each of A, B, and C.

Similarly, a list preceded by "a plurality of" (and variations thereon) and including "or" to separate listed elements indicates options of multiple instances of any or all of the listed elements. For example, the phrases "a plurality of A, B, or C" and "two or more of A, B, or C" indicate options of: A and B; B and C; A and C; and A, B, and C.

In general, the term "or" as used herein indicates exclusive alternatives (e.g., "one or the other but not both") when preceded by terms of exclusivity, such as, e.g., "either," "one of," or "exactly one of."

The articles "a," "an," and "the" are intended to include the plural forms as well, unless the context clearly indicates otherwise.

Any mark, if referenced herein, may be common law or registered trademarks of third parties affiliated or unaffiliated with the applicant or the assignee. Use of these marks is by way of example and shall not be construed as descriptive or to limit the scope of disclosed or claimed embodiments to material associated with such marks.

The terms "comprises," "includes," and "has" specify the presence of stated features, numbers, operations, members, elements, and/or combinations thereof, but do not preclude the presence or addition of one or more other features, numbers, operations, members, elements, and/or combinations thereof.

Throughout the application, unless context indicates otherwise, ordinal numbers (e.g., first, second, third, etc.) may be used as an adjective for an element (i.e., any noun in the application). Although terms such as "first," "second," and "third" may be used herein to describe various members, components, regions, layers, or sections, these members, components, regions, layers, or sections are not to be limited by these terms. Rather, these terms are used to distinguish one member, component, region, layer, or section from another member, component, region, layer, or section.

The use of ordinal numbers is not to imply or create any particular ordering of the elements nor to limit any element to being a single element unless expressly disclosed, such as by the use of the terms "before," "after," "single," and other such terminology. Rather, the use of ordinal numbers is to distinguish between the elements.

By way of an example, a first element is distinct from a second element, and the first element may encompass more than one element and succeed (or precede) the second element in an ordering of elements. Thus, a first member, component, region, layer, or section referred to in examples described herein may also be referred to as a second member, component, region, layer, or section without departing from the teachings of the examples.

Certain operations of methods according to the technology, or of systems executing those methods, may be represented schematically in the figures or otherwise discussed herein. Unless otherwise specified or limited, representation in the figures of particular operations in particular spatial order may not require those operations to be executed in a particular sequence corresponding to the particular spatial order. Correspondingly, certain operations represented in the figures, or otherwise disclosed herein, may be executed in different orders than are expressly illustrated or described, as appropriate for particular examples of the technology. Further, in some examples, certain operations may be executed in parallel or partially in parallel, including by dedicated parallel processing devices, or separate computing devices configured to interoperate as part of a large system.

The invention further comprises the following embodiments forming part of the description:
1. A device, comprising:
   a signal input;
   an operational amplifier (op-amp) comprising a non-inverting op-amp input coupled to the signal input, an inverting op-amp input, and an op-amp output;
   a summer comprising a first summer input coupled to the op-amp output, a second summer input coupled to the signal input, and a summer output; and
   a low-pass filter comprising a low-pass filter input coupled to the summer output and a low-pass filter output coupled to the inverting op-amp input.
2. The device of embodiment 1, wherein the summer comprises:
   a first resistor coupled in series to the op-amp output; and
   a second resistor coupled in series to the signal input;
   wherein the first resistor and the second resistor are each coupled in series to the filter input.
3. The device of embodiment 2, wherein the low-pass filter comprises a third resistor coupled in series to the first resistor and the second resistor.
4. The device of embodiment 3, wherein the third resistor comprises a polysilicon resistor, a switched capacitor resistor, a duty-cycled resistor, or a linearized metal-oxide semiconductor (MOS) resistor.
5. The device of embodiment 2, wherein the summer further comprises a buffer comprising a buffer input coupled to the signal input and a buffer output coupled to the second resistor.
6. The device of embodiment 5, wherein the summer further comprises a second low-pass filter comprising a second low-pass filter input coupled to the signal input and a second low-pass filter output coupled to the buffer input.
7. The device of embodiment 5, wherein the buffer has a voltage gain greater than unity.
8. The device of embodiment 2, further comprising:
   a first capacitor coupled in series to the op-amp output and the inverting op-amp input; and
   a second capacitor coupled in series to ground and the inverting op-amp input;
   wherein the low-pass filter is coupled to the inverting op-amp input in parallel to the first capacitor.
9. A system, comprising:
   an electrode; and
   a front-end amplifier comprising:
      a signal input coupled to the electrode;
      an operational amplifier (op-amp) comprising a non-inverting op-amp input coupled to the signal input, an inverting op-amp input, and an op-amp output;
      a signal output coupled to the op-amp output;
      a summer comprising a first summer input coupled between the op-amp output and the signal output, a second summer input coupled to the electrode, and a summer output; and
      a low-pass filter comprising a low-pass filter input coupled to the summer output and a low-pass filter output coupled to the inverting op-amp input.
10. The system of embodiment 9, wherein the summer comprises:
   a first resistor coupled in series to the op-amp output; and
   a second resistor coupled in series to the signal input;
   wherein the first resistor and the second resistor are each coupled in series to the filter input.
11. The system of embodiment 10, wherein the low-pass filter comprises a third resistor coupled in series to the first resistor and the second resistor.
12. The system of embodiment 10, wherein the summer further comprises a buffer comprising a buffer input coupled to the signal input and a buffer output coupled to the second resistor.
13. The system of embodiment 10, wherein the summer further comprises a second low-pass filter comprising a second low-pass filter input coupled to the signal input and a second low-pass filter output coupled to the buffer input.
14. The system of embodiment 10, further comprising:
   a first capacitor coupled in series to the op-amp output and the inverting op-amp input; and
   a second capacitor coupled in series to ground and the inverting op-amp input;
   wherein the low-pass filter is coupled to the inverting op-amp input in parallel to the first capacitor.
15. The system of embodiment 9, further comprising an analog-to-digital converter (ADC) coupled to the signal output.
16. A non-transitory computer-readable medium comprising stored instructions to manufacture a device, the device comprising:
   a signal input;
   an operational amplifier (op-amp) comprising a non-inverting op-amp input coupled to the signal input, an inverting op-amp input, and an op-amp output;
   a low-pass filter comprising a low-pass filter input and a low-pass filter output coupled to the inverting op-amp input;
   a first resistor coupled in series between the op-amp output and the low-pass filter input; and
   a second resistor coupled in series between the signal input and the low-pass filter input.
17. The non-transitory computer-readable medium of embodiment 16, wherein the low-pass filter comprises a third resistor coupled in series to the first resistor and the second resistor.
18. The non-transitory computer-readable medium of embodiment 16, wherein the device further comprises:
   a buffer comprising a buffer input coupled to the signal input and a buffer output coupled to the second resistor.
19. The non-transitory computer-readable medium of embodiment 18, wherein the device further comprises a second low-pass filter comprising a second low-pass filter input coupled to the signal input and a second low-pass filter output coupled to the buffer input.
20. The non-transitory computer-readable medium of embodiment 16, wherein the device further comprises:
   a first capacitor coupled in series to the op-amp output and the inverting op-amp input; and
   a second capacitor coupled in series to ground and the inverting op-amp input;
   wherein the low-pass filter is coupled to the inverting op-amp input in parallel to the first capacitor.

## Claims

1. A device, comprising:
a signal input;
an operational amplifier (op-amp) comprising a non-inverting op-amp input coupled to the signal input, an inverting op-amp input, and an op-amp output;
a summer comprising a first summer input coupled to the op-amp output, a second summer input coupled to the signal input, and a summer output; and
a low-pass filter comprising a low-pass filter input coupled to the summer output and a low-pass filter output coupled to the inverting op-amp input.

2. The device according to claim 1, wherein the summer comprises:
a first resistor coupled in series to the op-amp output; and
a second resistor coupled in series to the signal input;
wherein the first resistor and the second resistor are each coupled in series to the filter input.

3. The device according to claim 2, wherein the low-pass filter comprises a third resistor coupled in series to the first resistor and the second resistor.

4. The device according to claim 3, wherein the third resistor comprises a polysilicon resistor, a switched capacitor resistor, a duty-cycled resistor, or a linearized metal-oxide semiconductor (MOS) resistor.

5. The device according to claim 2, wherein the summer further comprises a buffer comprising a buffer input coupled to the signal input and a buffer output coupled to the second resistor.

6. The device according to claim 5, wherein the summer further comprises a second low-pass filter comprising a second low-pass filter input coupled to the signal input and a second low-pass filter output coupled to the buffer input, and/or
wherein the buffer has a voltage gain greater than unity.

7. The device according to claim 2, further comprising:
a first capacitor coupled in series to the op-amp output and the inverting op-amp input; and
a second capacitor coupled in series to ground and the inverting op-amp input;
wherein the low-pass filter is coupled to the inverting op-amp input in parallel to the first capacitor.

8. A system, comprising:
an electrode; and
a front-end amplifier comprising:
a signal input coupled to the electrode;
an operational amplifier (op-amp) comprising a non-inverting op-amp input coupled to the signal input, an inverting op-amp input, and an op-amp output;
a signal output coupled to the op-amp output;
a summer comprising a first summer input coupled between the op-amp output and the signal output, a second summer input coupled to the electrode, and a summer output; and
a low-pass filter comprising a low-pass filter input coupled to the summer output and a low-pass filter output coupled to the inverting op-amp input.

9. The system according to claim 8, wherein the summer comprises:
a first resistor coupled in series to the op-amp output; and
a second resistor coupled in series to the signal input;
wherein the first resistor and the second resistor are each coupled in series to the filter input.

10. The system according to claim 9, wherein the low-pass filter comprises a third resistor coupled in series to the first resistor and the second resistor, and/or
wherein the summer further comprises a buffer comprising a buffer input coupled to the signal input and a buffer output coupled to the second resistor, and/or
wherein the summer further comprises a second low-pass filter comprising a second low-pass filter input coupled to the signal input and a second low-pass filter output coupled to the buffer input.

11. The system according to claim 9, further comprising:
a first capacitor coupled in series to the op-amp output and the inverting op-amp input; and
a second capacitor coupled in series to ground and the inverting op-amp input;
wherein the low-pass filter is coupled to the inverting op-amp input in parallel to the first capacitor.

12. The system according to at least one of claims 8 to 11, further comprising an analog-to-digital converter (ADC) coupled to the signal output.

13. A non-transitory computer-readable medium comprising stored instructions to manufacture a device, the device comprising:
a signal input;
an operational amplifier (op-amp) comprising a non-inverting op-amp input coupled to the signal input, an inverting op-amp input, and an op-amp output;
a low-pass filter comprising a low-pass filter input and a low-pass filter output coupled to the inverting op-amp input;
a first resistor coupled in series between the op-amp output and the low-pass filter input; and
a second resistor coupled in series between the signal input and the low-pass filter input.

14. The non-transitory computer-readable medium according to claim 13, wherein the low-pass filter comprises a third resistor coupled in series to the first resistor and the second resistor, and/or
wherein the device further comprises:
a first capacitor coupled in series to the op-amp output and the inverting op-amp input; and
a second capacitor coupled in series to ground and the inverting op-amp input;
wherein the low-pass filter is coupled to the inverting op-amp input in parallel to the first capacitor.

15. The non-transitory computer-readable medium according to at least one of claims 13 or 14, wherein the device further comprises:
a buffer comprising a buffer input coupled to the signal input and a buffer output coupled to the second resistor, and
wherein the device in particular further comprises a second low-pass filter comprising a second low-pass filter input coupled to the signal input and a second low-pass filter output coupled to the buffer input.
